Europäisches Patentamt

European Patent Office

Office européen des brevets

(19)

(11) Veröffentlichungsnummer: **0 193 783**
**B1**

(12) # EUROPÄISCHE PATENTSCHRIFT

(45) Veröffentlichungstag der Patentschrift:
23.05.90

(51) Int. Cl.⁵: **G01N 24/08**

(21) Anmeldenummer: **86102087.3**

(22) Anmeldetag: **18.02.86**

(54) Hochfrequenzantennensystem für Kernspintomographiegeräte.

(30) Priorität: **06.03.85 DE 3507946**

(43) Veröffentlichungstag der Anmeldung:
**10.09.86 Patentblatt 86/37**

(45) Bekanntmachung des Hinweises auf die Patenterteilung:
**23.05.90 Patentblatt 90/21**

(84) Benannte Vertragsstaaten:
**DE FR GB**

(56) Entgegenhaltungen:
**EP-A- 0 073 375**
**EP-A- 0 154 996**
**EP-A- 0 156 979**
**DE-A- 3 347 597**
**FR-A- 2 530 816**

**JOURNAL OF MAGNETIC RESONANCE 36,1979,**
**Seiten 447-451**

(73) Patentinhaber: **Siemens Aktiengesellschaft,**
**Wittelsbacherplatz 2, D-8000 München 2(DE)**

(72) Erfinder: **Kestler, Joachim, Judengasse 4,**
**D-8551 Pretzfeld(DE)**

## Beschreibung

Die Erfindung bezieht sich auf eine Einrichtung zur Erzeugung und/oder zum Empfang von Hochfrequenzsignalen in einem Kernspintomographiegerät mit mindestens zwei, sich auf einer gedachten Zylindermantelfläche parallel zur Richtung der Zylinderachse erstreckenden, gegensinnig stromdurchflossenen Leiterstücken vorbestimmter Länge. In der DE-OS 31 33 432 wird eine derartige Antennenanordnung in Verbindung mit einer zusätzlichen Hülle, die für die vorliegende Erfindung jedoch nicht notwendigerweise erforderlich ist, beschrieben.

Bei supraleitenden Ganzkörpermagneten mit Feldstärken des Grundfeldes von 0,5 bis 2T liegen die Kernresonanzfrequenzen für Protonen im Bereich von 20 bis 85 MHz. Die dafür erforderlichen magnetischen Hochfrequenzfelder lassen sich in diesem Frequenzbereich mit reinen Induktivitäten (Spulen) nur noch sehr unvollkommen erzeugen, da sich mit zunehmender Frequenz die Wellenlänge immer mehr der Leiterlänge der Spulen nähert. Dadurch kommt es zu Phasenverschiebungen der Felder zwischen dem Leiteranfang und dem Leiterende der Spulen, die die Funktionsfähigkeit der das Hochfrequenzfeld erzeugenden Spule entsprechend vermindern. Aus diesem Grund benutzt man zur Erzeugung des magnetischen Hochfrequenzfeldes Resonatoren, die im einfachsten Fall aus den obengenannten zwei parallelen, gegensinnig gespeisten Leiterstücken gebildet werden.

Leitungsresonatoren für den gegebenen Bereich sind z. B. vorgeschlagen von H. J. Schneider und P. Dullenkopf in "Review Scientific Instruments", Vol. 48, 68 (1977) und in der DE-OS 31 33 432. In allen Fällen tritt jedoch an den Enden der dort beschriebenen Resonatoren ein elektrisches Feld auf, welches das Meßobjekt durchdringt und deshalb zu unerwünschten dielektrischen Verlusten führt, die das Signal/Rausch-Verhältnis verschlechtern und dadurch höhere Hf-Leistung erfordern. Außerdem ist das Magnetfeld nicht auf den Untersuchungsraum begrenzt, sondern greift weit über die Endern des Resonators hinaus, was ebenfalls zu underwünschten Verlusten führt und bei der Bildgebung zu Störsignalen aus unerwünschten Bereichen Anlaß geben kann.

Der vorliegenden Erfindung liegt die Aufgabe zugrunde, ein Hochfrequenzantennensystem für ein Kernspintomographiegerät der eingangs genannten Art so auszubilden, daß innerhalb eines weitgehend von elektrischen Hochfrequenzfeldern befreiten Meßvolumens ein homogenes magnetisches Hochfrequenzfeld vorliegt und daß außerhalb des Meßvolumens das magnetische Hochfrequenzfeld weitgehend reduziert wird.

Die Aufgabe wird erfindungsgemäß gemäß Patentanspruch 1 gelöst.

Das unerwünschte magnetische Feld außerhalb des Untersuchungsraumes wird, verglichen mit Resonatoren bisheriger Bauart, durch die Electroden deutlich reduziert. Die Elektroden verkörpern weiterhin die für eine Resonanz erforderlichen Abschlußkapazitäten. Sind die Elektroden beweglich angeordnet, so läßt sich durch Verschieben der Elektroden (parallel zur Richtung der Leiterstücke) die Resonanzfrequenz der Anordnung in relativ weiten Grenzen variieren (z.B. 60 bis 105 MHz).

Die Verwendung zusätzlicher Leiterstücke oder bandartiger Leiterquerschnitte kann die Homogenität des magnetischen Hochfrequenzfeldes weiter verbessern.

Die weiteren Ausgestaltungen der Erfindung sind mit den abhängigen Patentansprüchen gekennzeichnet.

Die erfindungsgemäße Anordnung ist auch für Zirkularpolarisation verwendbar, wenn ein zweites, parallel zum ersten und um einen Winkel $\alpha$ um die Zylinderachse versetztes Paar von Wellenleitern hinzugefügt wird. Bei exakt rotationssymmetrischem Aufbau ($\alpha$ = 90°) wird dadurch an der Stromverteilung innerhalb der beiden Hälften nichts verändert, so daß keine elektrischen Verkopplungen auftreten. Beide Resonatorsysteme werden durch Verschieben der gemeinsamen Elektroden abgestimmt. Dabei ist ein zusätzlicher Feinabgleich etwa mittels als Trimmkapazität wirkender Blechstreifen an einem System vorzusehen, um zum Beispiel fertigungsbedingte Abweichungen der Resonanzfrequenzen auszugleichen.

Die Erfindung is nachfolgend anhand von in der Zeichnung dargestellten Ausführungsbeispielen näher erläutert. Es zeigen:

Fig. 1 und 2 den Aufbau eines Hochfrequenzantennensystems (Resonator) nach der Erfindung in zwei verschiedenen Ansichten,

Fig. 3 den Verlauf der magnetischen Feldstärke bei dem System nach Figur 1, und

Fig. 4 ein Hochfrequenzantennensystem nach der Erfindung für Zirkularpolarisation.

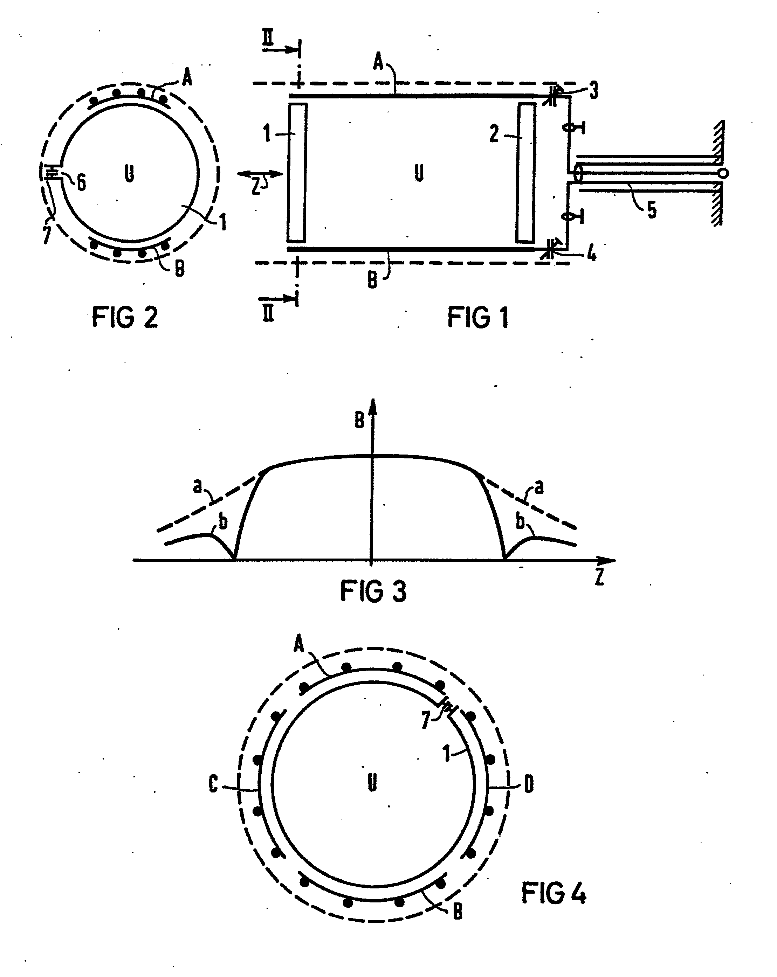

Gemäß Figur 1 wird der Untersuchungsraum U durch Stabsysteme A und B, welche je aus vier, auf einer gedachten Zylindermantelfläche liegenden, zur Zylinderachse parallelen Leiterstücken bestehen, eingeschlossen. Die Richtung der gedachten Zylinderachse bzw. der Leiterstücke sei im folgenden als die Z-Richtung bezeichnet. Im Abstand von den Stabsystemen A, B sind, koaxial zur Zylinderachse, ringförmige Elektroden 1, 2 aus Metall, vorzugsweise aus Metallbändern, angeordnet.

Zur Anpassung des Resonators an eine 50 Ohm Leitung sind verschiedene Varianten (z.B. auch induktive Kopplung) denkbar. Eine in der Praxis bewährte Schaltung ist in Figur 1 dargestellt. Die variablen Koppelkondensatoren 3 und 4 gestatten es, den Resonator sowohl im Leerlauf (z. B. bei Phantomtests) als auch mit Belastung durch einen Patienten exakt anzupassen. Die dabei auftretende Verschiebung der Resonanzfrequenz kann leicht durch Nachjustage einer Elektrode 1 oder 2 ausgeglichen werden. Um die elektrische Symmetrie des Resonanzkreises nicht zu stören, wird die Anordnung erdsymmetrisch gespeist. Hierzu dient ein $\lambda$/4-Sperrtopf 5, der aus der Literatur auch als "Lindenblad-Topf" bekannt ist.

Die Figur 2 zeigt eine Schnittdarstellung nach der Linie II durch das Antennensystem.

Um eine Störung der zur Bildgebung notwendigen Gradientenfelder durch Wirbelströme zu vermeiden, sind die aus Metallband (z.B. Kupfer) gefertigten Elektroden 1 und 2 an einer Stelle 6 unterbrochen. Diese Unterbrechungen werden jedoch durch Zuschalten von geeigneten Festkapazitäten 7 für die Hf-Ströme unwirksam gemacht.

Die Figur 3 zeigt qualitativ den Verlauf des Hf-Magnetfeldes in Abhängigkeit von der z-Koordinate. Das unerwünschte äußere Feld wird - verglichen mit Resonatoren bisheriger Bauart (Verlauf a) - durch die Ringkondensatoren deutlich reduziert (Verlauf b).

Die Figur 4 zeigt eine mögliche Anordnung der Resonatorstabsysteme bei Zirkularpolarisation des Hochfrequenzfeldes. Das zweite hinzugefügte Stabsystempaar C und D liegt auf derselben Zylindermantelfläche wie das erste Paar, ist jedoch gegenüber diesem um 90° bezüglich der Zylinderachse gedreht angebracht.

Es sei darauf hingewiesen, daß die Ausführungsbeispiele der vorliegenden Erfindung sowohl zum Anregen der Kernresonanz als auch für den Empfang der vom Untersuchungskörper ausgesandten Kernresonanzsignale geeignet sind.

## Patentansprüche

1. Einrichtung zur Erzeugung und/oder zum Empfang von Hochfrequenzsignalen in einem Kernspintomographiegerät mit mindestens zwei, sich auf einer gedachten Zylindermantelfläche parallel zur Richtung der Zylinderachse erstreckenden, gegensinnig stromdurchflossenen Leiterstücken (A, B) vorbestimmter Länge, dadurch gekennzeichnet, daß im Bereich der Enden der Leiterstücke (A, B) Elektroden (1, 2) in Form von ringförmigen, den Untersuchungsraum umgebenden Körpern vorgesehen sind, die für die Leiterstücke jeweils eine für die Resonanz erforderliche Abschlußkapazität bilden und die in Längsrichtung der Zylinderachse d.h. in Z-Richtung verschiebbar sind.

2. Hochfrequenzeinrichtung nach Anspruch 1, dadurch gekennzeichnet, daß die ringförmigen Körper an einer Stelle (6) elektrisch unterbrochen sind.

3. Hochfrequenzeinrichtung nach Anspruch 2, dadurch gekennzeichnet, daß die Unterbrechungen durch Kapazitäten (7) überbrückt sind.

## Claims

1. Device for generating and/or receiving high-frequency signals in a nuclear spin tomography device with at least two conductor parts (A, B) of a predetermined length, carrying opposing currents and extending on an assumed cylinder lateral surface parallel to the direction of the cylinder axis, characterised in that in the region of the ends of the conductor parts (A, B) electrodes (1, 2) in the form of annular bodies surrounding the testing area are provided which form in each case for the conductor parts a terminating capacitor necessary for the resonance and which are displaceable in the longitudinal direction of the cylinder axis, i.e. in Z-direction.

2. High-frequency device according to claim 1, characterised in that the annular bodies are interrupted electrically at one point (6).

3. High-frequency device according to claim 2, characterised in that the interruptions are bridged by capacitors (7).

## Revendications

1. Dispositif pour générer et/ou pour recevoir des signaux haute fréquence dans un appareil de tomographie à résonance magnétique nucléaire, comprenant au moins deux portions de conducteurs (A, B) de longueur prédéterminée, s'étendant sur une surface latérale cylindrique, fictive, parallèlement à la direction de l'axe du cylindre et qui sont traversés dans des sens opposés par un courant, caractérisé en ce que des électrodes (1, 2), sous la forme de corps annulaires entourant l'espace d'examen, sont prévues dans la région des électrodes des portions de conducteurs (A, B), électrodes qui forment chacune une capacité terminale nécessaire à la résonance des segments de conducteurs et qui sont déplaçables en translation dans la direction longitudinale de l'axe du cylindre, c'est-à-dire dans la direction Z.

2. Dispositif à haute fréquence selon la revendication 1, caractérisé en ce que les corps annulaires sont interrompues électriquement à un endroit (6).

3. Dispositif à haute fréquence selon la revendication 2, caractérisé en ce que les interruptions sont shuntées par des capacités (7).

EP 0 193 783 B1

FIG 2

FIG 1

FIG 3

FIG 4